# EUROPÄISCHE PATENTSCHRIFT

(11) **EP 0 447 829 B1**
(45) Veröffentlichungstag und Bekanntmachung des Hinweises auf die Patenterteilung: **24.09.1997**
(21) Anmeldenummer: 91102605.2
(22) Anmeldetag: 22.02.1991
(51) Int. Cl.: G03F 3/10, G03F 7/023

(54) **Gefärbtes, positiv arbeitendes, lichtempfindliches Aufzeichnungsmaterial und Verfahren zur Herstellung eines Farbprüfbildes unter Verwendung dieses Materials**
Coloured positive working light sensitive recording material and process for the production of a colour proofing image using this material
Matériau d'enregistrement photosensible à l'effet positif coloré et procédé de production d'une image d'épreuve en couleurs utilisant ce matériau

(30) Priorität: 05.03.1990 DE 4006856
(43) Veröffentlichungstag der Anmeldung: 25.09.1991
(73) Patentinhaber: Agfa-Gevaert AG, 51373 Leverkusen (DE)
(72) Erfinder: Mohr, Dieter, Dr. Dipl.-Chem., W-6501 Budenheim (DE); Benzing, Martin, Dr. Dipl.-Chem., W-6501 Mommenheim (DE); Mertes, Jürgen, Dr. Dipl.-Chem., W-6507 Ingelheim (DE); Hultzsch, Günter, Dr. Dipl.-Chem., W-6200 Wiesbaden (DE); Gramm, Ine, W-6200 Wiesbaden (DE); Michel, Manfred, Dr. Dipl.-Chem., W-6200 Wiesbaden (DE); Elsässer, Andreas, Dr. Dipl.-Chem., W-6270 Idstein (DE); Hsieh, Shane, Dr. Dipl.-Chem., Bridgewater, New Jersey 08807 (US); Siegfried, David, Dr. Dipl.-Chem., Langhorne, Pennsylvania 19047 (US)

(56) Entgegenhaltungen:
- EP-A- 0 115 899
- EP-A- 0 357 324
- EP-A- 0 357 325

## Beschreibung

Die vorliegende Erfindung betrifft ein positiv arbeitendes gefärbtes lichtempfindliches Aufzeichnungsmaterial zur Herstellung eines Farbprüfbildes, bestehend aus einem temporären Schichtträger, einer Farbstoff oder Pigment, Bindemittel und Chinondiazidverbindung enthaltenden lichtempfindlichen Schicht und einer thermisch aktivierbaren Klebeschicht sowie ein Verfahren zur Herstellung eines Farbprüfbildes unter Verwendung dieses Materials.

Im Mehrfarbendruck wird im allgemeinen eine Farbprüfung vorgenommen, um die Korrektur der für die Belichtung von Druckplatten verwendeten Farbauszüge zu ermöglichen. Das Farbprüfbild muß ein getreues Abbild des gewünschten Raster- oder Strichbildes sein und soll den Tonwert der Farben naturgetreu, d.h. weder erhöht noch herabgesetzt wiedergeben. Die visuelle Farbprüfung soll Fehler in der Vorlage anzeigen, die beste Farbwiedergabe, die beim Drucken in der Maschine zu erwarten ist, ermöglichen, die genaue Gradation aller Farbtöne wiedergeben und aufzeigen, ob die Grautöne neutral sind. Sie soll ferner die eventuelle Notwendigkeit zur Abschwächung einer der Farben angeben und/oder Hinweise zur Änderung der Filmvorlage vor der Herstellung der Druckplatten liefern.

Die Farbprüfung für den Mehrfarbendruck wird bisher mit Hilfe von Farbandrucken vorgenommen. Dabei müssen alle auch beim tatsächlichen Mehrfarbendruck notwendigen Schritte unternommen werden. Ein solches Farbprüfverfahren ist kostspielig und zeitaufwendig, und man hat deshalb andere Farbprüfverfahren entwickelt, die dem Andruck in der Qualität gleichkommen sollen. Drei Farbprüfverfahren mittels lichtempfindlicher Farbprüffolien sind bekannt, das Surprint-Verfahren (Übereinanderlaminieren), das Surlay-Verfahren (Übereinanderkopieren), und das Overlay-Verfahren (Übereinanderlegen).

Die DE-A 27 12 864, entsprechend GB-A 1 550 524, beschreibt eine positiv arbeitende Farbfolie, die aus einem transparenten Schichtträger, einer lichtempfindlichen Diazoniumsalz enthaltenden Schicht, und einer dünnen Farbschicht mit einem darin dispergierten Pigment besteht. Kennzeichnend ist für diese Farbprüffolie eine spezielle Schichtenanordnung, wobei in jedem Fall die Schicht mit der lichtempfindlichen Diazoniumverbindung, bezogen auf das Stadium der Belichtung, über der Farbschicht liegen soll.

Die EP-A 0 035 028, entsprechend US-A 4 260 673, bezieht sich auf einen vorsensibilisierten Farbprüfbogen, der folgenden Schichtaufbau zeigt: Ein Trägerblatt ist mit einer Antihaftfläche bedeckt, auf der eine Farbschicht aufgetragen ist, danach folgt eine Novolak enthaltende Bindemittelschicht, die ein Reaktionsprodukt eines Harzes und eines Diazooxids enthält und frei von Pigmenten ist.

Auf diese Bindemittelschicht folgen dann noch eine Sperrschicht und eine Antihaftschicht.

Die EP-A 0 217 792 betrifft ein Verfahren zur Verbesserung der Belichtungsbreite von positiv arbeitenden Farbprüffolien, bei dem als optisches Filter eine gefärbte Trennschicht verwendet wird. Aus EP-A 0 165 030 ist eine Farbprüffolie bekannt, die zusätzlich zu dem sonstigen Schichtaufbau auch noch einen oder mehrere Farbstoffe enthält, die einen Reflexionsschutz bewirken ("antihalation layer").

In der EP-A 0 165 031, entsprechend US-A 4 656 114, wird ein Farbprüfblatt offenbart, bei dem zwischen der Farbschicht und der Adhäsivschicht noch eine zusätzliche wasserunlösliche, transparente Trennschicht liegt, durch die nach dem Auflösen der Adhäsivschicht Diffusion aus einer Farbschicht in eine andere Farbschicht verhindert werden soll.

Vorrangiges Ziel dieser bekannten Farbprüfverfahren ist es, ein Mehrfarbenbild zu erzeugen, das dem angestrebten Vierfarbendruck in seinem Aussehen möglichst nahe kommt. Der entscheidende Nachteil dieser positiv arbeitenden Aufzeichnungsmaterialien zur Herstellung von Farbprüffolien scheint darin zu liegen, daß diese Materialien Novolakharze in Kombination mit Chinondiazid-Verfahren als lichtreaktives System verwenden. Da Novolake eine gelb bis braune Färbung besitzen, führt dies zwangsläufig zu einer Farbtonverschiebung bei dem zu erstellenden Farbprüfbild. Damit sind alle bisher bekannten Farbprüfsysteme, die von vorgefärbten, Novolak enthaltenden Schichten ausgehen, als ein Kompromiß zwischen Photoreaktivität und Farbwiedergabe anzusehen.

In der EP-A 0 179 274, entsprechend US-A 4 659 642, wird versucht, die Farbverschiebung durch die Eigenfärbung des Novolaks dadurch zu vermeiden, daß man phenolgruppenfreie Bindemittel einsetzt. Dies führt jedoch noch nicht zu praxisgerechten Materialien, da die Löslichkeitsdifferenzierung zwischen belichteten und unbelichteten Bereichen unzureichend ist.

Zur Herstellung von Farbprüffolien für die graphische Industrie sind verschiedene Verfahren bekannt, die von vorgefärbten Schichten ausgehen. Die US-A 3 671 236 beschreibt ein Verfahren, bei dem nacheinander Teilfarbenbilder in den verschiedenen Grundfarben gemäß den entsprechenden Farbauszügen auf ein Empfangsblatt zu einem Vierfarb-Gesamtbild zusammengesetzt werden.

In der US-A 37 21 557, entsprechend DE-B 19 12 864, wird ein Verfahren zur Übertragung von Farbbildern beschrieben bei dem zwischen der lichtempfindlichen Schicht und dem Schichtträger eine Abziehschicht aufgebracht ist. Wenn die lichtempfindliche Schicht entwickelt wird, werden die löslichen Bestandteile der Schicht selektiv entfernt und es entsteht ein sichtbares Bild. Der Schichtträger mit dem Bild wird gegen ein geeignetes klebstoffbeschichtetes Empfangsmaterial gepreßt und dann die Bildübertragung durch Abziehen des Schichtträgers vorgenommen. Für jede weitere Bildübertragung wird eine frische Klebstoffschicht auf das Empfangsmaterial aufgetragen.

Aus der DE-A 22 36 941, entsprechend US-A 4 093 464, ist ein Farbprüfverfahren bekannt, bei dem positiv arbeitende lichtempfindliche Schichten, die in den gewünschten Grundfarben eingefärbt sind und sich jeweils auf einer temporären Trägerfolie befinden, auf dieser Folie belichtet und entwickelt werden. Die erhaltenen Teilfarbenbilder werden auf ein Bildempfangsmaterial, z.B. ein Bedruckpapier, durch Laminieren im Register übertragen. Dieses Verfahren hat den Nachteil, daß das Laminieren im Register sehr präzises Arbeiten erfordert und deshalb sehr aufwendig ist. Auch läßt sich das Laminieren von entwickelten Bildern nur mit Schichten durchführen, die noch ausreichend thermoplastisch sind, also in der Regel nur mir positiv arbeitenden Schichten, die zudem noch bestimmte plastifizierende Zusätze enthalten.

Gemäß EP-A 0 035 028 wird zur Herstellung eines Mehrfarben-Prüfbildes das mehrschichtige Material auf ein Bildempfangsmaterial, das ein wasserfest ausgerüstetes Papier darstellt, laminiert, dort belichtet und zum Teilfarbenbild entwickelt. Die übrigen Teilfarbenbilder werden über dem ersten in gleicher Weise erzeugt. Nach diesem Verfahren lassen sich passergenaue Mehrfarbenbilder leichter erhalten, da nur im Register belichtet zu werden braucht. Das Verfahren hat den Nachteil, daß es für jede Grundfarbe mehrere übereinanderliegende Schichten erfordert und daß die Bildelemente noch jeweils zwei Schichten mit unzersetzter gefärbter Diazoverbindung enthalten.

Aufgabe der vorliegenden Erfindung war es ein lichtempfindliches Aufzeichnungsmaterial für den Mehrfarbenandruck anzugeben, das eine farbortgetreue Wiedergabe ermöglicht und einen ausreichenden Entwicklerkontrast zwischen belichteten und unbelichteten Bereichen ergibt.

Bei einem positiv arbeitenden gefärbten lichtempfindlichen Aufzeichnungsmaterial der eingangs genannten Art, bei dem sich auf der Oberfläche des temporären Schichtträgers eine Trennschicht auf der Basis von Polyvinylalkohol befindet und dessen lichtempfindliche Schicht als Chinondiazidverbindung ein Veresterungsprodukt aus einer Verbindung mit einer oder mehreren phenolischen Hydroxylgruppen und o-Chinondiazidsulfonsäurechlorid und als Bindemittel ein novolakfreies, phenolisches Polymerharz und/oder ein Umsetzungsprodukt des Polymerharzes mit einem Monoisocyanat enthält, wird diese Aufgabe dadurch gelöst, daß die Klebeschicht 70-99 Gew.% Styrol-Butadien-Copolymerisat und 1-30% eines alkali-löslichen Polyester enthält.

Ein Aufzeichnungsmaterial mit den Merkmalen des oberbegriffs von Anspruch 1 ist aus der EP-A-0 115 899 bekannt.

Für die Trennschicht auf der Basis von Polyvinylalkohol kommen teilverseifte Polyvinylacetate infrage, besonders solche mit einem Hydrolysegrad von 80 bis 90 Molprozent.

Das novolakfreie, phenolische Polymerharz ist vorzugsweise ein Polymerisat mit phenolischen Gruppen in der Seitenkette entsprechend der allgemeinen Formel I 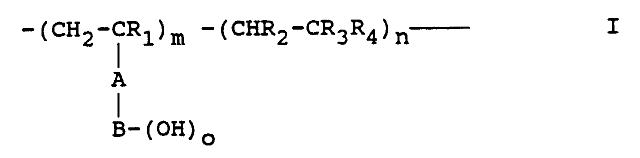 worin
- R₁: Wasserstoff oder eine Methylgruppe,
- R₂: Wasserstoff oder eine Carboxylgruppe,
- R₃: Wasserstoff, Alkyl oder ein Halogenatom,
- R₄: Alkyl, Alkoxy, Alkoxycarbonyl, Acyl, Acyloxy, Aryl, Formyl, Cyano, Carboxyl oder Hydroxyl und im Falle, daß R₂ eine Carboxylgruppe ist, mit dieser zu einem Säureanhydrid verbunden sein kann,
- A: eine Einfachbindung oder die Gruppe 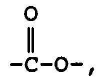
- B: ein gegebenenfalls substituiertes ein- oder zweikerniges carbocyclisches aromatisches Ringsystem,
- m: 100 bis 60 Molprozent,
- n: 0 bis 40 Molprozent und
- o: 1 oder 2
bedeuten.

Insbesondere wird ein Bindemittel eingesetzt, das ein Polymerisat entsprechend der allgemeinen Formel I ist, in der
- R₁: Wasserstoff oder eine Methylgruppe,
- R₂: Wasserstoff oder eine Carboxylgruppe,
- R₃: Wasserstoff,(C₁-C₁₂)-Alkyl oder ein Halogenatom,
- R₄: Alkyl, Alkoxy, Alkoxycarbonyl mit jeweils 1 bis 4 Kohlenstoffatomen, Acyl, Acyloxy, Aryl, Formyl, Cyano, Carboxyl oder Hydroxyl und im Falle, daß R₂ eine Carboxylgruppe ist, mit dieser zu einem Säureanhydrid verbunden sein kann,
- A: eine Einfachbindung oder die Gruppe 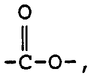
- B: Phenylen oder Naphtylen, die durch Niederalkyl, Niederalkoxy, Aryl oder Halogen substituiert sein können,
bedeuten.

Besonders geeignete Polymerharze als Bindemittel sind Homo- oder Copolymerisate aus Brenzkatechinmonomethacrylat, Resorcinmonomethacrylat, Hydrochinonmonomethacrylat und 4-Hydroxystyrol, die allein oder im Gemisch vorhanden sind.

Das als Bindemittel eingesetzte Polymerharz läßt sich nach konventionellen Methoden, beispielsweise in Gegenwart eines Polymerisationsinitiators wie Azo-bis-isobuttersäurenitril in organischen Lösemitteln wie Tetrahydrofuran oder Methylethylketon bei erhöhten Temperaturen innerhalb von 1 bis 20 Stunden herstellen. Daneben ist aber auch eine Suspensions- oder Massepolymerisation möglich, die durch Strahlung, Hitze oder ionische Initiatoren ausgelöst werden kann. Die Polymerisate mit Einheiten der Formel I können Homopolymerisate, welche ausschließlich Struktureinheiten der Formel I enthalten, oder Mischpolymerisate aus Monomeren entsprechend der Formel I und einem oder mehreren anderen Vinylmonomeren, gegebenenfalls auch solchen mit phenolischen Gruppen, sein.

Beispiele hierfür sind Styrol, α-Chlorstyrol, α-Methylstyrol, 2-, 3- oder 4-Chlormethylstyrol, 4-Bromstyrol, Methylvinylether, Ethylvinylether, Propylvinylether, Butylvinylether, Acrylnitril, Acrolein, Butadien, Acrylsäure, Methacrylsäure, die Methyl-, Ethyl-, Propyl-, Butyl-, Pentyl-, Hexyl-, Octyl-, Decyl-, Dodecyl-, 2-Ethyl-hexyl-, Phenyl-, Benzyl-, Biphenyl- oder Naphthylester dieser Säuren, Methacrylamid, Acrylamid, Vinylacetat, Vinylisobutylketon und Maleinsäureanhydrid. Comonomere mit phenolischen Hydroxylgruppen haben bevorzugt die folgenden Strukturen:

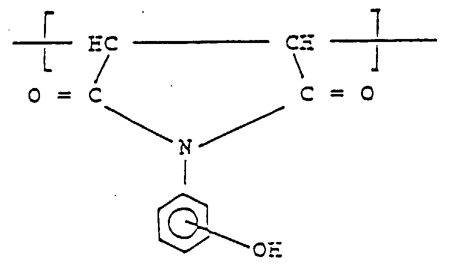

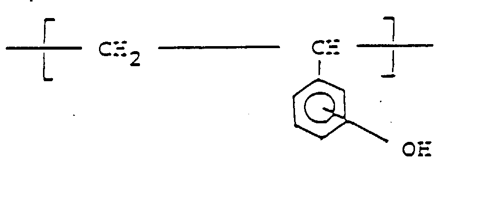

Das Molekulargewicht des Polymerisats kann in weiten Grenzen variiert werden. Die Polymerisate mit M = 20.000-50.000 werden dabei bevorzugt.

Die Hydroxylzahl liegt allgemein im Bereich von 100-450, vorzugsweise zwischen 200 und 350. Der Mengenateil an phenolischen Hydroxylgruppen enthaltenden Einheiten im Polymerisat richtet sich nach der praktischen Lichtempfindlichkeit der verschieden eingefärbten lichtempfindlichen Schichten. Der Mengenanteil wird weiter bestimmt durch die rasche Entwicklung mit wäßrig-alkalischen Lösungen und durch eine möglichst große Entwicklerresistenz der unbelichteten Bereiche. Die gewünschte Hydrophilie wird durch Umsetzung der OH-Gruppen mit z.B. Monoisocyanaten eingestellt. Geeignete Isocyanate sind beispielsweise Butylisocyanat, Cyclohexylisocyanat, n-Propylisocyanat. Vorzugsweise ist das Monoisocyanat des Umsetzungsproduktes mit dem phenolischen Polymerharz Phenylisocyanat.

Die Menge an Monoisocyanat liegt im Bereich von 0-30 Gewichtsprozent bezogen auf das anwesende Polymere.

Das Bindemittel ist in der gefärbten lichtempfindlichen Schicht in einem Anteil von 20 bis 75, vorzugsweise 30 bis 70 Gewichtsprozent, bezogen auf die nichtflüchtigen Anteile der Schicht vorhanden.

Zur Herstellung der erfindungsgemäßen Gemische für die lichtempfindliche Schicht wird das beschriebene Bindemittel mit einer farbgebenden Komponente und einer lichtempfindlichen Verbindung kombiniert. Hierzu gehören vor allem o-Chinondiazide. Als o-Chinondiazide können Kondensationsprodukte aus einer Verbindung mit einer oder mehreren phenolischen Hydroxylgruppen und 1,2-Naphthochinon-(2)-diazid-4-sulfonsäurechlorid, 1,2-Naphthochinon-(2)-diazid-5-sulfonsäurechlorid oder auch 1,2-Naphthochinon-(2)-diazid-6-sulfonsäurechlorid vorhanden sein. Zu den Verbindungen mit einer oder mehreren phenolischen Hydroxylgruppen gehören z.B. Trihydroxybenzophenon, Bisphenol-A oder 4-tert. Butylphenol. Als o-Chinondiazide werden vorzugsweise Veresterungsprodukte des 1,2-Naphthochinon-(2)-diazid-4-sulfonsäurechlorids mit 2,3,4-Trihydroxybenzophenons verwendet, die nach dem Belichten keine Farbverschiebung der Farbprüffolie verursachen. Als Veresterungsprodukt aus 2,3,4-Trihydroxybenzophenon und 1,2-Naphthochinon-(2)-diazid-4-sulfonsäurechlorid kommen die Mono-, Bis- und Trisester infrage. Ganz besonders bevorzugt wird der Trisester eingesetzt. Die Menge an o-Chinondiazidverbindung beträgt im allgemeinen 10-30%, bezogen auf die nichtflüchtigen Bestandteile des lichtempfindlichen Gemisches.

Zu den erfindungsgemäß geeigneten Farbmitteln zählen verschiedene Farbstoff- und Pigmentklassen in den Grundfarben Magenta, Cyan, Gelb und Schwarz. Zur Erzielung bestimmter Farbtöne können auch Mischungen der verschiedenen Farbstoffe oder Pigmente verwendet werden. In der am meisten bevorzugten Ausführung werden Pigmente mit einer durchschnittlichen Teilchengröße von höchstens 1 µm eingesetzt.

Die einzelnen Komponenten werden in verträglichen Lösemitteln, wie z.B. Propylenglykolmonomethylether, Ethylenglykolmonomethylether, -Butyrolacton und Methylglykol gelöst und auf die Oberfläche des temporären Schichtträgers aufgetragen und getrocknet. Die lichtempfindliche Schicht hat ein Schichtgewicht von 0,5 bis 5,0 g/m². Insbesondere liegt das Schichtgewicht zwischen 0,8 und 2,0 g/m².

Der temporäre Schichtträger muß zumindest eine trennfähige Oberfläche aufweisen, d.h. er muß fähig sein, die lichtempfindliche Schicht so zu halten, daß sie wieder von ihm getrennt werden kann. Zu diesem Zweck kann entweder die Schichtträgeroberfläche von ihrer Natur her trennfähig sein, sie kann durch eine geeignete Behandlung trennfähig gemacht werden, oder sie kann mit einer Trennschicht versehen werden. Als eine derartige Trennschicht dient erfindungsgemäß eine Schicht auf Basis von Polyvinylalkohol. Zu den geeigneten Polymeren gehören z.B. Polyvinylalkohol und dessen Partialester, Polyvinylether und -acetate, Copolymerisate aus Vinylalkohol und Olefinen, die allein oder im Gemisch eingesetzt werden können. Vorzugsweise dient als Polymer für die Trennschicht ein teilverseiftes Polyvinylacetat mit einem Hydrolysegrad von 80 bis 90 Molprozent. Die Trennschicht besitzt ein Trockenschichtgewicht im Bereich von etwa 0,5 bis 2 g/m².

Die thermisch aktivierbare Klebeschicht besteht vorzugsweise aus einem Alkali unlöslichen organischen Polymerisat und einem Alkali löslichen Polyesterharz, dessen Erweichungspunkt dabei weniger als 160 °C, vorzugsweise weniger als 100 °C betragen sollte. Zudem sollte die Klebeschicht bei Raumtemperatur nicht klebrig sein. Dazu gehören z.B. Polyvinylacetat, Polyacrylsäureester, Acrylsäureester-Copolymere, Polymethacrylsäureester, Methacrylsäureester-Copolymere, Polyvinylchlorid, Vinylchlorid-Copolymere, Polystyrol, Styrol-Copolymere, Polyesterharze und Ethylen-Copolymere (z.B. Ethylen/Vinylacetat Copolymere, Ethylen/Acrylsäure-Copolymere).

Die Klebeschicht enthält 70 - 99, vorzugsweise 60 - 95 Gewichtsprozent an Styrol-Butadien Copolymerisat und 1 - 30, vorzugsweise 5 - 40 Gewichtsprozent alkalilöslichen Polyester.

Die vorstehend beschriebenen Materialien können gegebenenfalls auch weitere Komponenten, wie z.B. UV-Absorber, Antistatika und Weichmacher enthalten.

Die Klebeschicht wird üblicherweise aus einem organischen Lösemittel auf die lichtempfindliche Schicht aufgebracht. Dabei wird eine Vermischung der beiden Schichten dadurch vermieden, daß man ein Lösungsmittel verwendet, das die lichtempfindliche untere Schicht nicht angreift. Das Trockengewicht der Klebeschicht liegt im Bereich von 2-20 g/m², bevorzugt von etwa 3-10 g/m².

Die bildmäßig belichteten Schichten können in bekannter Weise mit wäßrig alkalischen Lösungen entwickelt werden. Die wäßrigen Entwicklerlösungen können z.B. Alkaliphosphate, -silikate oder -hydroxide und ferner Netzmittel sowie geringe Mengen an organischem Lösemittel enthalten.

Die Erfindung betrifft auch ein Verfahren zur Herstellung eines Farbprüfbildes unter Verwendung des erfindungsgemäßen gefärbten lichtempfindlichen Aufzeichnungsmaterials, bei dem man ein Aufzeichnungsmaterial in der ersten Grundfarbe klebeschichtseitig auf einen permanenten Schichtträger mit Hilfe von Druck und Wärme auflaminiert, den temporären Schichtträger abzieht, das Aufzeichnungsmaterial unter dem Farbauszug der entsprechenden Grundfarbe belichtet und entwickelt und über dem erhaltenen Teilbild in weiterer entsprechender Weise Teilbilder der weiteren Grundfarben und von Schwarz erzeugt, wodurch das komplette Vierfarbenbild entsteht.

Zur Herstellung eine Farbprüfbildes wird der Schichtverbund über die Klebeschicht auf einen permanenten Schichtträger unter Druck und Erwärmen laminiert, die lichtempfindliche Schicht nach dem Entfernen des temporären Schichtträgers bildmäßig belichtet und die belichtete Schicht durch Auswaschen der belichteten Bereiche entwickelt. Zur Erstellung eines kompletten Farbprüfbildes wird ein weiteres lichtempfindliches Aufzeichnungsmaterial in einer anderen Grundfarbe über das zuvor hergestellte Bild auf denselben permanenten Schichtträger laminiert. Um die gesamte Farbwiedergabe zu erhalten, werden normalerweise vier Schichten in den Farben Cyan, Magenta, Gelb und Schwarz verwendet.

Die erfindungsgemäße lichtempfindliche Schicht ist in besonderer Weise zur Herstellung von Farbprüfbildern auf einem geeigneten permanenten Schichtträgermaterial geeignet, da sie eine Farbverschiebung des Farbprüfbildes durch Novolake vermeidet durch den Einsatz farbloser Polymerharze, die durch ihren Gehalt an phenolischen Gruppen, wie Novolake lösungsinhibierend auf Chinondiazid-Verbindungen wirken und in der Lichtreaktion phenolgruppenfreien Harzen deutlich überlegen sind.

Darüberhinaus läßt sich erfindungsgemäß die praktische Lichtempfindlichkeit durch Modifikation der phenolischen Hydroxylgruppen mit Monoisocyanaten einstellen.

Als permanenter Schichtträger können Kunstoff-Folien, z.B. Polyesterfolien oder kunststoffbeschichtete Papiere verwendet werden. Die Oberfläche des permanenten Schichtträgers hat vorzugsweise eine rauhe Oberfläche und/oder ist haftvermittelnd behandelt worden. Der permanente Schichtträger muß unempfindlich gegen die Laminier- und Entwicklungsvorgänge sein.

Durch die Erfindung wird erreicht, daß man nunmehr ein positiv arbeitendes gefärbtes lichtempfindliches Aufzeichnungsmaterial zur Herstellung eines Farbprüfbildes zur Verfügung stellen kann, das eine naturgetreue Farbwiedergabe gewährleistet, das in einem einfachen Verfahren leicht handhabbar ist, einen breiten Verarbeitungsspielraum und eine gute Entwicklerresistenz der unbelichteten Bereiche besitzt.

Die Erfindung wird an Hand der Beispiele näher erläutert ohne sie hierauf zu beschränken. Sofern nicht anders angegeben, beziehen sich alle Teil- und Prozentangaben auf das Gewicht.

Das folgende Beispiel bezieht sich auf die Herstellung einer Cyan eingefärbten Farbprüffolie.

### Beispiel 1

Auf eine 50 µm dicke Folie aus Polyethylenterephthalat als temporärer Schichtträger wird eine Trennschicht aufgebracht, die ein Trockengewicht von 0,7 - 1,0 g/m² hat. Die Lösung wird aufgerakelt und bei 100°C im Trockenschrank für 3 Minuten getrocknet.

### Beschichtungslösung A

| | |
|---|---|
| Polyvinylalkohol | 120,0 g |
| (Pw=530, Hydrolysegrad 88 Mol.-%) | |
| Polyvinylalkohol | 120,0 g |
| (Pw=1000, Hydrolysegrad 88 Mol.-%) | |
| Nonylphenolpolyglykolether | 6,7 g |
| deionisiertes Wasser | 6,8 kg |

Im folgenden Schritt wird auf die Trennschicht die gefärbte lichtempfindliche Schicht mit Hilfe einer Schleuder aufgebracht. Die Beschichtungslösung für die lichtempfindliche Schicht stellt man in zwei Stufen her. Zuerst wird die Pigmentdispersion hergestellt.

### Beschichtungslösung B

| | |
|---|---|
| Polyvinylpropionalharz mit 13,6 % Vinylacetat-, 9,8 % Vinylalkohol- und 76,6 % Vinylpropionalgruppen | 5,5 % |
| Hostapermblau B2G Blaupigment, Color Index | 6,5 % |
| (C.I.) 74160 | |
| Propylenglykolmonomethylether | 44,0 % |
| γ- Butyrolacton | 44,0 % |

### Beschichtungslösung C

| | |
|---|---|
| Polymerisat aus Brenzkatechinmonomethacrylat | 12,5 g |
| (RSV-Wert: 0,210 in Dimethylformamid -DMF-) | |
| Beschichtungslösung B | 6,5 g |
| Veresterungsprodukt aus | 1,1 g |
| 1 Mol 2,3,4-Trihydroxybenzophenon und | |
| 3 Mol 1,2-Naphthochinon-(2)-diazid-4-sulfonsäurechlorid | |
| Propylenglykolmonomethylether | 36,4 g |
| Tetrahydrofuran | 43,5 g |

Die Lösung wird auf die mit einer Trennschicht versehene Folie so aufgeschleudert, daß sich nach dem Trocknen (2 Minuten, 110 °C) ein Schichtgewicht von 1,5 g/m² einstellt. Die Farbdichte, gemessen mit einem Gretag Densitometer durch einen Blau-Filter, beträgt 1,2.

Auf die gefärbte lichtempfindliche Schicht wird abschließend noch eine Klebeschicht bestehend aus 97 Gewichtsprozent eines Styrol-Butadien-Copolymerisates (Tg = 50 °C) und 3 Gewichtsprozent eines alkali-löslichen Polyesters (Desmophen^{R} 1700, BAYER AG) mit einem Trockengewicht von 3 g/m² aufgebracht.

Die so erhaltene Farbprüffolie wird mit der Klebeschicht auf ein Empfangsblatt als permanentem Schichtträger laminiert. Geeignete Laminiertemperaturen liegen im Bereich von 110-140 °C. Nach dem Laminieren wird die Folie als temporärer Schichtträger abgezogen. Die Klebeschicht und die gefärbte lichtempfindliche Schicht bleiben dabei auf dem permanenten Schichtträger zurück.

Die lichtempfindliche Schicht wird dann in bekannter Weise bildmäßig belichtet. Es kann z.B. mit einer UV-Lichtquelle durch eine Photomaske im Vakuumkopierrahmen belichtet werden.

Nach dem Belichten wird mit einer wäßrig-alkalischen Lösung die aus

| | |
|---|---|
| Wasser | 92 Gewichtsteile |
| Natriumoctylsulfat | 3 " " |
| Kaliummetasilikat | 3 " " |
| Phenoxyethanol | 1 " " |
| Trinatriumphosphat | 1 " " |

besteht, entwickelt, wobei die vom Licht getroffenen löslichen Anteile der Schicht entfernt werden.

Man erhält eine getreue Wiedergabe der Originalfarbauszugs.

Um ein vollständiges Farbbild herzustellen, werden in derselben Weise nacheinander je eine magenta-, gelb- und schwarz-eingefärbte Folie auflaminiert, der jeweilige temporäre Schichtträger abgezogen, belichtet und entwickelt, so daß eine genaue Wiedergabe des Originals, von dem man die Farbauszüge hergestellt hat, erfolgt.

### Beispiele 2-7

Zum Vergleich wird das Polymerisat aus Beispiel 1 mit den in der Tabelle angegebenen Mengen Phenylisocyanat modifiziert und analog zu Beispiel 1 eine Farbprüffolie hergestellt und jeweils mit derselben Entwicklerlösung entwickelt. In Tabelle 1 sind die eingesetzten Polymerisate sowie die offenen Keilstufen in UGRA-Keil bei gleichen Belichtungszeiten sowie die Auflösungen für die einzelnen Schichten zusammengestellt.

**Tabelle 1**

| Beispiel | Gew.-% Phenylisocyanat | offene Stufe | µ-Linie stehend |
|---|---|---|---|
| 2 | 0,9 | 5 | 55 |
| 3 | 1,8 | 4 | 40 |
| 4 | 3,6 | 3 | 30 |
| 5 | 5,5 | 2 | 25 |
| 6 | 7,3 | 2 | 15 |
| 7 | 9,1 | 1 | 8 |

Die Tabelle zeigt, daß die Hydrophilie der Bebilderungsschicht durch die Menge an Phenylisocyanat leicht variiert werden kann.

### Beispiele 8-11

Zur Herstellung einer Farbprüffolie werden die folgenden Bindemittel entsprechend den Angaben der Beschichtungslösung C mit den dort angegebenen Komponenten gemischt:
8) Copolymerisat aus Brenzkatechinmonomethacrylat und Methylacrylat (90:10 Mol-%, RSV-Wert: 0,438 dl/g in Dimethylformamid)
9) Copolymerisat aus Hydrochinonmonomethacrylat und n-Butylmethacrylat (70:30 Mol.-%, RSV-Wert: 0,365 dl/g in Dimethylformamid)
10) Copolymerisat aus Resorcinmonomethacrylat und 2-Ethylhexylmethacrylat(68:32 Mol-%, RSV: 0,589 dl/g in Dimethylformamid)
11) Copolymerisat aus 4-Hydroxystyrol und n-Butylmethacrylat (70:30 Mol-%, RSV: 0,321 dl/g in Dimethylformamid)

Nach dem Laminieren, Belichten und Entwickeln erhält man eine getreue Wiedergabe des Originalfarbauszuges.

In Tabelle 2 sind die eingesetzten Copolymerisate sowie die offenen Keilstufen im UGRA-Keil bei gleichen Belichtungszeiten sowie die Auflösungen für die einzelnen Schichten zusammengestellt.

**Tabelle 2**

| Beispiel | offene Stufe | µ-Linie stehend |
|---|---|---|
| 8 | 4 | 40 |
| 9 | 2 | 8 |
| 10 | 2 | 8 |
| 11 | 6 | 70 |

## Patentansprüche

1. Positiv arbeitendes gefärbtes lichtempfindliches Aufzeichnungsmaterial zur Herstellung eines Farbprüfbildes, bestehend aus einem temporären Schichtträger, einer Farbstoff oder Pigment, Bindemittel und Chinondiazidverbindung enthaltenden lichtempfindlichen Schicht und einer thermisch aktivierbaren Klebeschicht, bei dem sich auf der Oberfläche des temporären Schichtträgers eine Trennschicht auf der Basis von Polyvinylalkohol befindet, und dessen lichtempfindliche Schicht als Chinondiazidverbindung ein Veresterungsprodukt aus einer Verbindung mit einer oder mehreren phenolischen Hydroxylgruppen und o-Chinondiazidsulfonsäurechlorid und als Bindemittel ein novolakfreies, phenolisches Polymerharz und/oder ein Umsetzungsprodukt des phenolischen Polymerharzes mit einem Monoisocyanat enthält, dadurch gekennzeichnet daß die Klebeschicht 70 bis 99 Gew.-% Styrol-Butadien-Copolymerisat und 1 bis 30 Gew.-% eines alkalilöslichen Polyesters enthält.

2. Aufzeichnungsmaterial nach Anspruch 1, dadurch gekennzeichnet, daß die Trennschicht aus einem teilverseiften Polyvinylacetat mit einem Hydrolysegrad von 80 bis 90 Molprozent besteht

3. Aufzeichnungsmaterial nach Anspruch 1, dadurch gekennzeichnet, daß die lichtempfindliche Schicht als Bindemittel ein Polymerharz nach der allgemeinen Formel I enthält: 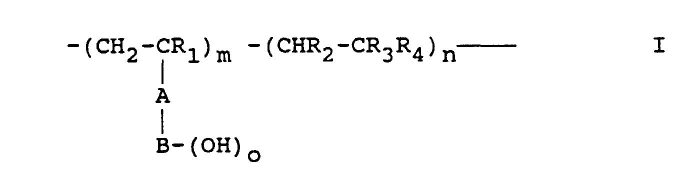 worin
R₁ Wasserstoff oder eine Methylgruppe,
R₂ Wasserstoff oder eine Carboxylgruppe,
R₃ Wasserstoff, Alkyl oder ein Halogenatom,
R₄ Alkyl, Alkoxy, Alkoxycarbonyl, Acyl, Acyloxy, Aryl, Formyl, Cyano, Carboxyl oder Hydroxyl und im Falle, daß R₂ eine Carboxylgruppe ist, mit dieser zu einem Säureanhydrid verbunden sein kann,
A eine Einfachbindung oder die Gruppe 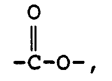
B ein gegebenenfalls substituiertes ein- oder zweikerniges carbocyclisches aromatisches Ringsystem,
m 100 bis 60 Molprozent,
n 0 bis 40 Molprozent und
o 1 oder 2
bedeuten.

4. Aufzeichnungsmaterial nach Anspruch 1 oder 3, dadurch gekennzeichnet, daß als Bindemittel ein Polymerharz nach der allgemeinen Formel I vorhanden ist,
worin R₁ Wasserstoff oder eine Methylgruppe,
R₂ Wasserstoff oder eine Carboxylgruppe,
R₃ Wasserstoff,(C₁-C₁₂)-Alkyl oder ein Halogenatom,
R₄ Alkyl, Alkoxy, Alkoxycarbonyl mit jeweils 1 bis 4 Kohlenstoffatomen, Acyl, Acyloxy, Aryl, Formyl, Cyano, Carboxyl oder Hydroxyl und im Falle, daß R₂ eine Carboxylgruppe ist, mit dieser zu einem Säureanhydrid verbunden sein kann,
A eine Einfachbindung oder die Gruppe 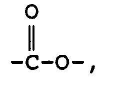
B Phenylen oder Naphtylen, die durch Niederalkyl, Niederalkoxy, Aryl oder Halogen substituiert sein können,
bedeuten.

5. Aufzeichnungsmaterial nach Ansprüchen 1, 3 und 4, dadurch gekennzeichnet, daß als Bindemittel ein Homo- oder Copolymerisat aus der Gruppe Brenzkatechinmonomethacrylat, Resorcinmonomethacrylat, Hydrochinonmethacrylat oder 4-Hydroxystyrol allein oder im Gemisch vorhanden ist.

6. Aufzeichnungsmaterial nach Anspruch 1, dadurch gekennzeichnet, daß das Monoisocyanat des Umsetzungsproduktes mit dem phenolischen Polymerharz Phenylisocyanat ist.

7. Aufzeichnungsmaterial nach Anspruch 1 oder 6, dadurch gekennzeichnet, daß das Monoisocyanat in einem Anteil von 0 - 30 Gewichtsprozent, bezogen auf das Polymere vorhanden ist.

8. Aufzeichnungsmaterial nach Anspruch 1, dadurch gekennzeichnet, daß als Chinondiazidverbindung ein Veresterungsprodukt des 1,2-Naphthochinon-(2)-diazid-4-oder -5-sulfonsäurechlorids mit 2,3,4-Trihydroxybenzophenon, Bisphenol-A oder 4-tert.-Butylphenol vorhanden ist.

9. Aufzeichnungsmaterial nach Anspruch 8, dadurch gekennzeichnet, daß als Chinondiazidverbindung ein Veresterungsprodukt des 1,2-Naphthochinon-(2)-diazid-4-sulfonsäurechlorids mit 2,3,4-Trihydroxybenzophenon vorhanden ist.

10. Aufzeichnungsmaterial nach Ansprüchen 1, 8 oder 9, dadurch gekennzeichnet, daß die Chinondiazidverbindung in einer Menge von 10 bis 30 Gewichtsprozent, bezogen auf die nichtflüchtigen Bestandteile des lichtempfindlichen Gemisches vorhanden ist.

11. Aufzeichnungsmaterial nach Anspruch 1, dadurch gekennzeichnet, daß in der lichtempfindlichen Schicht jeweils ein oder mehrere Farbstoffe oder Pigmente der Grundfarben Cyan, Magenta, Gelb und Schwarz vorhanden sind.

12. Verfahren zur Herstellung eines Farbprüfbildes unter Verwendung des gefärbten lichtempfindlichen Aufzeichnungsmaterials nach Ansprüchen 1 bis 11, bei dem man ein Aufzeichnungsmaterial in der ersten Grundfarbe klebeschichtseitig auf einen permanenten Schichtträger mit Hilfe von Druck und Wärme auflaminiert, den temporären Schichtträger abzieht, das Aufzeichnungsmaterial unter dem Farbauszug der entsprechenden Grundfarbe belichtet und entwickelt und über dem erhaltenen Teilbild in weiterer entsprechender Weise Teilbilder der weiteren Grundfarben und von Schwarz erzeugt, wodurch das komplette Vierfarbenbild entsteht.

## Claims

1. Positive-working coloured light-sensitive recording material for the production of a colour proofing image, consisting of a temporary support, a dye or pigment, binder and quinonediazide-containing light-sensitive layer and an adhesive layer capable of being thermally activated, wherein a separating layer based on polyvinyl alcohol is positioned on the surface of the temporary support and the light-sensitive layer of the said material contains, as quinonediazide compound, an esterification product of a compound having one or more phenolic hydroxyl groups and of o-quinonediazide sulphonyl chloride and, as binder, a novolak-free, phenolic polymer resin and/or a reaction product of the phenolic polymer resin with a monoisocyanate, characterised in that the adhesive layer contains from 70 to 99 wt.% of styrene-butadiene copolymer and from 1 to 30 wt.% of an alkali-soluble polyester.

2. Recording material according to claim 1,
characterised in that the separating layer consists of a partly saponified polyvinyl acetate having a degree of hydrolysis of from 80 to 90 mol per cent.

3. Recording material according to claim 1,
characterised in that the light-sensitive layer contains as binder a polymer resin corresponding to the general formula I: 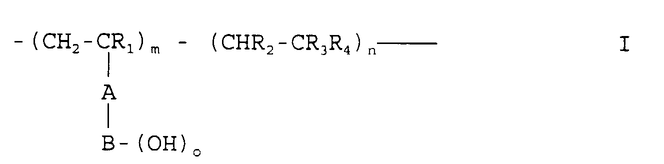 wherein
R₁ denotes hydrogen or a methyl group,
R₂ denotes hydrogen or a carboxyl group,
R₃ denotes hydrogen, alkyl or a halogen atom,
R₄ denotes alkyl, alkoxy, alkoxycarbonyl, acyl, acyloxy, aryl, formyl, cyano, carboxyl or hydroxyl and, where R₂ is a carboxyl group, may be bonded with the latter to form an acid anhydride,
A denotes a single bond or the group 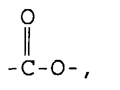
B denotes an optionally substituted mononuclear or binuclear carbocyclic aromatic ring system,
m is 100 to 60 mol per cent,
n is 0 to 40 mol per cent and
o is 1 or 2.

4. Recording material according to claim 1 or 3,
characterised in that the binder present is a polymer resin corresponding to the general formula I,
wherein
R₁ denotes hydrogen or a methyl group,
R₂ denotes hydrogen or a carboxyl group,
R₃ denotes hydrogen, (C₁-C₁₂)-alkyl or a halogen atom,
R₄ denotes alkyl, alkoxy, alkoxycarbonyl, each having 1 to 4 carbon atoms, acyl, acyloxy, aryl, formyl, cyano, carboxyl or hydroxyl and, where R₂ is a carboxyl group, may be bonded with the latter to form an acid anhydride,
A denotes a single bond or the group 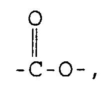
B denotes phenylene or naphthylene, which may be substituted by lower alkyl, lower alkoxy, aryl or halogen.

5. Recording material according to claims 1, 3 and 4,
characterised in that the binder present is a homopolymer or copolymer selected from among catechol monomethacrylate, resorcinol monomethacrylate, hydroquinone methacrylate or 4-hydroxystyrene, alone or as a mixture.

6. Recording material according to claim 1,
characterised in that the monoisocyanate of the reaction product with the phenolic polymer resin is phenyl isocyanate.

7. Recording material according to claim 1 or 6,
characterised in that the monoisocyanate is present in a proportion of from 0 to 30 per cent by weight, based on the polymer.

8. Recording material according to claim 1,
characterised in that the quinonediazide compound present is an esterification product of 1,2-naphthoquinon-(2)-diazide 4- or 5-sulphonyl chloride with 2,3,4-trihydroxybenzophenone, bisphenol A or 4-tertiary butyl phenol.

9. Recording material according to claim 8,
characterised in that the quinonediazide compound present is an esterification product of 1,2-naphthoquinon-(2)-diazide 4-sulphonyl chloride with 2,3,4-trihydroxybenzophenone.

10. Recording material according to claims 1, 8 or 9,
characterised in that the quinonediazide compound is present in a quantity of from 10 to 30 per cent by weight, based on the non-volatile constituents of the light-sensitive mixture.

11. Recording material according to claim 1,
characterised in that one or more dyes or pigments of each of the primary colours cyan, magenta, yellow and black are present in the light-sensitive layer.

12. A process for the production of a colour proofing image using the coloured light-sensitive recording material according to claims 1 to 11, wherein the adhesive side of a recording material in the first primary colour is laminated by means of pressure and heat to a permanent support, the temporary support is peeled off, the recording material is exposed under the colour separation filter of the corresponding primary colour and developed, and partial images in the other primary colours and in black are further produced in corresponding manner on top of the partial image obtained, by which means the complete four-coloured image is formed.

## Revendications

1. Matériau d'enregistrement photosensible coloré à traitement positif pour la préparation d'une épreuve couleurs, constitué par un support de couche temporaire, par une couche photosensible contenant un colorant ou un pigment, un liant et un composé de quinone-diazide, et par une couche adhésive activable par voie thermique, dans lequel une couche de séparation à base d'alcool polyvinylique est disposée sur la surface du support de couche temporaire et dont la couche photosensible contient, à titre de composé de quinone-diazide, un produit d'estérification constitué par un composé contenant un ou plusieurs groupes hydroxyle phénoliques et un chlorure d'acide o-quinone-diazide-sulfonique et, à titre de liant, une résine polymère phénolique exempte de novolaque et/ou un produit réactionnel de la résine polymère phénolique avec un monoisocyanate, caractérisé en ce que la couche adhésive contient, à concurrence de 70 à 99% en poids, un copolymère de styrène-butadiène et, à concurrence de 1 à 30% en poids, un polyester soluble dans les alcalis.

2. Matériau d'enregistrement selon la revendication 1, caractérisé en ce que la couche de séparation est constituée par un acétate de polyvinyle partiellement saponifié possédant un degré d'hydrolyse de 80 à 90 moles %.

3. Matériau d'enregistrement selon la revendication 1, caractérisé en ce que la couche photosensible contient, à titre de liant, une résine polymère répondant à la formule générale I: 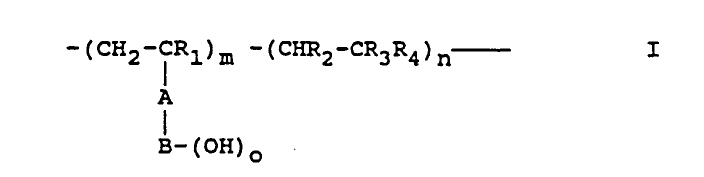 dans laquelle
R₁ représente un atome d'hydrogène ou un groupe méthyle,
R₂ représente un atome d'hydrogène ou un groupe carboxyle,
R₃ représente un atome d'hydrogène, un groupe alkyle ou un atome d'halogène,
R₄ représente un groupe alkyle, un groupe alcoxy, un groupe alcoxycarbonyle, un groupe acyle, un groupe acyloxy, un groupe aryle, un groupe formyle, un groupe cyano, un groupe carboxyle ou un groupe hydroxyle et, dans le cas où R₂ représente un groupe carboxyle, il peut être relié à ce dernier pour former un anhydride d'acide,
A représente une liaison simple ou le groupe 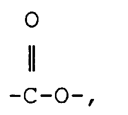
B représente un système à noyau aromatique carbocyclique mono- ou binucléaire éventuellement substitué,
m représente de 100 à 60 moles %,
n représente de 0 à 40 moles % et
o représente 1 ou 2.

4. Matériau d'enregistrement selon la revendication 1 ou 3, caractérisé en ce qu'est présente, à titre de liant, une résine polymère répondant à la formule générale I
dans laquelle
R₁ représente un atome d'hydrogène ou un groupe méthyle,
R₂ représente un atome d'hydrogène ou un groupe carboxyle,
R₃ représente un atome d'hydrogène, un groupe alkyle en C₁-C₁₂ ou un atome d'halogène,
R₄ représente un groupe alkyle, un groupe alcoxy, un groupe alcoxycarbonyle, chacun de ces groupes contenant de 1 à 4 atomes de carbone, un groupe acyle, un groupe acyloxy, un groupe aryle, un groupe formyle, un groupe cyano, un groupe carboxyle ou un groupe hydroxyle et, dans le cas où R₂ représente un groupe carboxyle, il peut être relié à ce dernier pour former un anhydride d'acide,
A représente une liaison simple ou le groupe 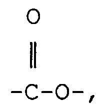
B représente un groupe phénylène ou un groupe naphtylène qui peuvent porter un ou plusieurs substituants identiques ou différents alkyle inférieur, alcoxy inférieur, aryle ou halogéno.

5. Matériau d'enregistrement selon les revendications 1, 3 et 4, caractérisé en ce qu'est présent, à titre de liant, un homo- ou un copolymère choisi parmi le groupe comprenant le monométhacrylate de pyrocatéchine, le monométhacrylate de résorcine, le monométhacrylate d'hydroquinone ou le 4-hydroxystyrène, seuls ou en mélanges.

6. Matériau d'enregistrement selon la revendication 1, caractérisé en ce que le monoisocyanate du produit réactionnel avec la résine polymère phénolique est l'isocyanate de phényle.

7. Matériau d'enregistrement selon la revendication 1 ou 6, caractérisé en ce que le monoisocyanate est présent en une fraction de 0-30% en poids rapportés au polymère.

8. Matériau d'enregistrement selon la revendication 1, caractérisé en ce qu'est présent, à titre de composé de quinone-diazide, un produit d'estérification du chlorure de l'acide 1,2-naphtoquinone-(2)-diazide-4- ou -5-sulfonique avec la 2,3,4-trihydroxybenzophénone, le Bisphénol A ou le 4-tert.-butylphénol.

9. Matériau d'enregistrement selon la revendication 8, caractérisé en ce qu'est présent, à titre de composé de quinone-diazide, un produit d'estérification du chlorure de l'acide 1,2-naphtoquinone-(2)-diazide-4-sulfonique avec la 2,3,4-trihydroxybenzophénone.

10. Matériau d'enregistrement selon la revendication 1, 8 ou 9, caractérisé en ce que le composé de quinone-diazide est présent en une quantité de 10 à 30% en poids rapportés aux composants non volatils du mélange photosensible.

11. Matériau d'enregistrement selon la revendication 1, caractérisé en ce que sont présents dans la couche photosensible, respectivement un ou plusieurs colorants ou pigments des couleurs de base cyano, magenta, jaune et noir.

12. Procédé pour la préparation d'une épreuve couleurs en utilisant le matériau d'enregistrement photosensible coloré selon les revendications 1 à 11, dans lequel on contrecolle un matériau d'enregistrement dans la première couleur de base côté couche adhésive sur un support de couche permanent à l'aide de pression et de chaleur, on pellicule le support de couche temporaire, on expose et on développe le matériau d'enregistrement en sélectionnant la couleur de base correspondante et on forme, par-dessus l'image partielle obtenue, de manière toujours correspondante, des images partielles des autres couleurs de base et de noir, ce qui permet d'obtenir l'image quadrichrome complète.
